# EUROPEAN PATENT APPLICATION

(11) **EP 4 498 406 A1**
(43) Date of publication of application: **29.01.2025**
(21) Application number: 24174351.7
(22) Date of filing: 06.05.2024
(51) Int. Cl.: H01L 21/336, H01L 29/76, B82Y 10/00, H01L 29/423

(54) **NANOMAGNET FOR SPIN-BASED QUANTUM-DOT QUBIT**

(30) Priority: 26.07.2023 US 202318359327
(71) Applicant: The Boeing Company, Arlington, VA 22202 (US)
(72) Inventor: MEI, Antonio, Arlington, VA 22202 (US); FEENEY, Colin Patrick, Arlington, VA 22202 (US); SMETANKA, Valerie, Arlington, VA 22202 (US); TABOADA, Mariano Josue, Arlington, VA 22202 (US); HO, Vinh, Arlington, VA 22202 (US); CROWELL, Jack Arnold, II, Arlington, VA 22202 (US); SABBIR, Golam, Arlington, VA 22202 (US); MILOSAVLJEVIC, Ivan, Arlington, VA 22202 (US); HA, Wonill, Arlington, VA 22202 (US)
(74) Representative: Lissandrini, Marco

(57) **Abstract**

A quantum computing device is provided, including a plurality of spin-based quantum-dot qubits that each include one or more quantum dots. The plurality of spin-based quantum-dot qubits also each include a nanomagnet including an amorphous ferromagnetic alloy.

## Description

### FIELD

The present disclosure relates generally to the field of quantum computing, and more specifically to quantum computing devices that include spin-based quantum-dot qubits.

### BACKGROUND

In quantum computing devices, computations are performed on information encoded in quantum states known as qubits. In some quantum computing devices, known as spin-based quantum computing devices, qubits are physically instantiated in the spins of charge carriers. The charge carriers may be electrons or electron holes in semiconductor devices. The electrons or electron holes that are used as qubits in spin-based quantum computing devices are confined in quantum dots. When quantum computations are performed, the quantum states of the qubits are modified by influencing the spins of the electrons or electron holes.

### SUMMARY

According to one aspect of the present disclosure, a quantum computing device is provided, including a plurality of spin-based quantum-dot qubits that each include one or more quantum dots. The plurality of spin-based quantum-dot qubits also each include a nanomagnet including an amorphous ferromagnetic alloy.

According to another aspect of the present disclosure, a nanomagnet is provided. The nanomagnet is configured to apply an external magnetic field to one or more quantum dots included in a spin-based quantum computing device. The nanomagnet includes an amorphous ferromagnetic alloy.

According to another aspect of the present disclosure, a spin-based quantum-dot qubit is provided. The spin-based quantum-dot qubit includes a first silicon layer in which a first quantum dot and a second quantum dot are located. The spin-based quantum-dot qubit further includes a silicon-germanium (SiGe) alloy layer located above the first silicon layer in a thickness direction. The spin-based quantum-dot qubit further includes a second silicon layer located above the SiGe alloy layer in the thickness direction. The spin-based quantum-dot qubit further includes a plurality of plunger gates and a plurality of barrier gates located above the second silicon layer in the thickness direction. The spin-based quantum-dot qubit further includes a nanomagnet located above the plurality of plunger gates and the plurality of barrier gates in the thickness direction. The nanomagnet includes an amorphous ferromagnetic alloy.

### BRIEF DESCRIPTION OF THE DRAWINGS

FIG. 1 shows an energy level plot of the energy levels of a quantum dot as a function of magnetic field strength, according to one example.
FIG. 2A shows an example top view of a quantum computing device including a qubit grid and a measurement device, according to one example.
FIG. 2B shows the qubit grid of FIG. 2A in additional detail.
FIG. 3 shows a vertical cross-sectional view of a spin-based quantum-dot qubit, according to the example of FIG. 2A.
FIG. 4A shows an example cross-sectional view of a portion of a conventional nanomagnet formed from a crystalline ferromagnetic material, according to the example of FIG. 2A.
FIG. 4B shows an example cross-sectional view of a portion of a nanomagnet including an amorphous ferromagnetic alloy, according to the example of FIG. 2A.

### DETAILED DESCRIPTION

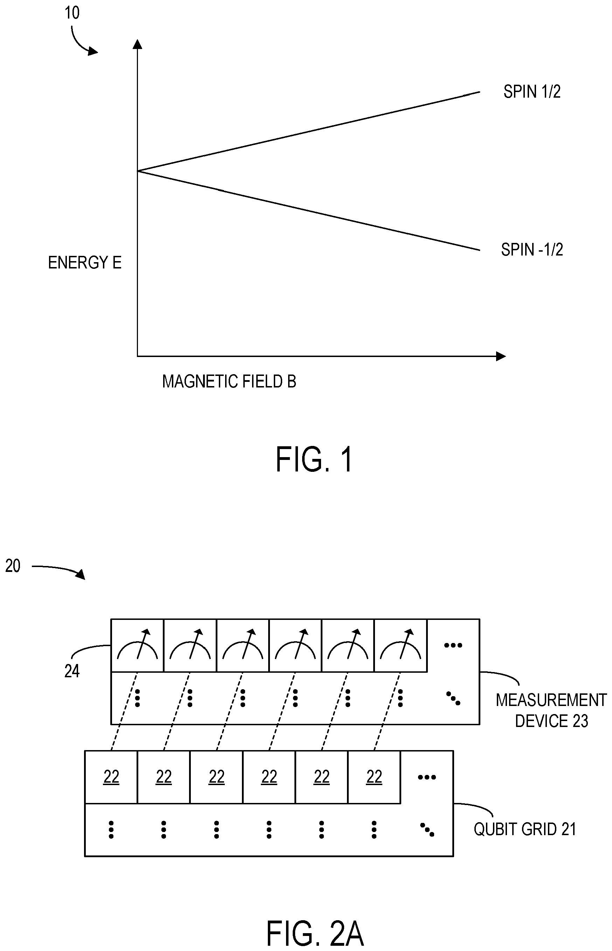

Spin-based quantum computing devices utilize the Zeeman effect when measuring the spins of charge carriers. The Zeeman effect is an effect on the energy levels of a charged particle that occurs when the particle is subjected to a magnetic field. FIG. 1 shows an energy level plot 10 of the energy levels of a quantum dot as a function of magnetic field strength. In the example of FIG. 1, an electron is confined within the quantum dot. When the magnetic field is applied, the energy E of the electron confined within the quantum dot splits into two different energy levels. These energy levels correspond to the electron having a spin of 1/2 and a spin of -1/2, respectively. The spins of the electrons confined within quantum dots are controlled in order to perform quantum computations at a quantum computing device.

FIG. 2A shows an example top view of a portion of a quantum computing device 20, according to one example. The quantum computing device 20, as shown in FIG. 2A, includes a qubit grid 21 at which a plurality of qubits 22 are instantiated. The qubit grid 21 is coupled to a measurement device 23 that includes a plurality of measurement circuits 24 coupled to corresponding qubits 22. Thus, the measurement circuits 24 are configured to obtain classical bits as outputs of quantum computations performed at the qubit grid 21 by measuring the quantum states of the qubits 22. By performing measurements at the qubit grid 21, the quantum states of the qubits 22 are also modified during the execution of quantum algorithms. In some examples, the measurement circuits 24 are configured to measure tunneling between the quantum dots and respective charge reservoirs. In other examples, the measurement circuits 24 are configured to obtain charge states that correspond to the spin states of the electrons confined at the quantum dots.

Although, in the example of FIG. 2A, the plurality of qubits 22 are arranged in a rectangular grid, the plurality of qubits 22 may be arranged in some other pattern in other quantum computing device configurations. Additionally or alternatively, other configurations of the plurality of measurement circuits 24 may be used in other example quantum computing devices.

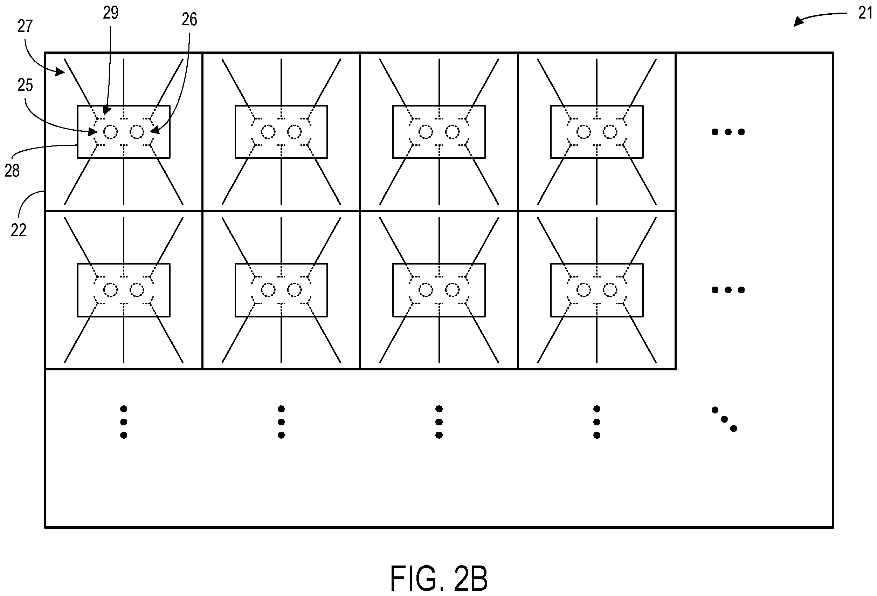

FIG. 2B shows the qubit grid 21 of FIG. 2A in additional detail, according to one example. In the qubit grid 21 depicted in FIG. 2B, the plurality of qubits 22 are spin-based quantum-dot qubits. The spin-based quantum-dot qubits 22 each include one or more quantum dots. In the example of FIG. 1, each of the plurality of spin-based quantum-dot qubits 22 is a double-quantum-dot qubit that includes a first quantum dot 25 and a second quantum dot 26. In other examples, the spin-based quantum-dot qubits 22 may be single-quantum-dot qubits.

In the example qubit grid 21 of FIG. 2B, a plurality of electrical leads 27 are electrically coupled to the first quantum dot 25 and the second quantum dot 26. The electrical leads 27 are configured to apply a voltage to the first quantum dot 25 and the second quantum dot 26. In addition, a plurality of gate electrodes 29 are provided at the electrical leads 27, as discussed in further detail below. The gate electrodes 29 are configured to be opened and closed to adjust the energy levels of the first quantum dot 25 and the second quantum dot 26.

In the example qubit grid 21 shown in FIG. 2B, the spin-based quantum-dot qubits 22 further include respective nanomagnets 28. The nanomagnets 28 are provided above a surface of the qubit grid 21 in the example of FIG. 2B. In the example of FIG. 2B, each qubit 22 has a respective nanomagnet 28 located above it. In other examples, a plurality of the qubits 22 have a shared nanomagnet. Via the nanomagnet 28, the first quantum dot 25 and the second quantum dot 26 are subjected to a magnetic field that produces the energy level splitting discussed above with reference to FIG. 1.

In some examples, during manufacturing of the quantum computing device 20, the nanomagnets 28 are formed via sputter deposition. The nanomagnets 28 may be subjected to an external magnetic field when sputter deposition is performed in order to align the magnetic moments of the atoms included in the nanomagnets 28, as discussed in further detail below.

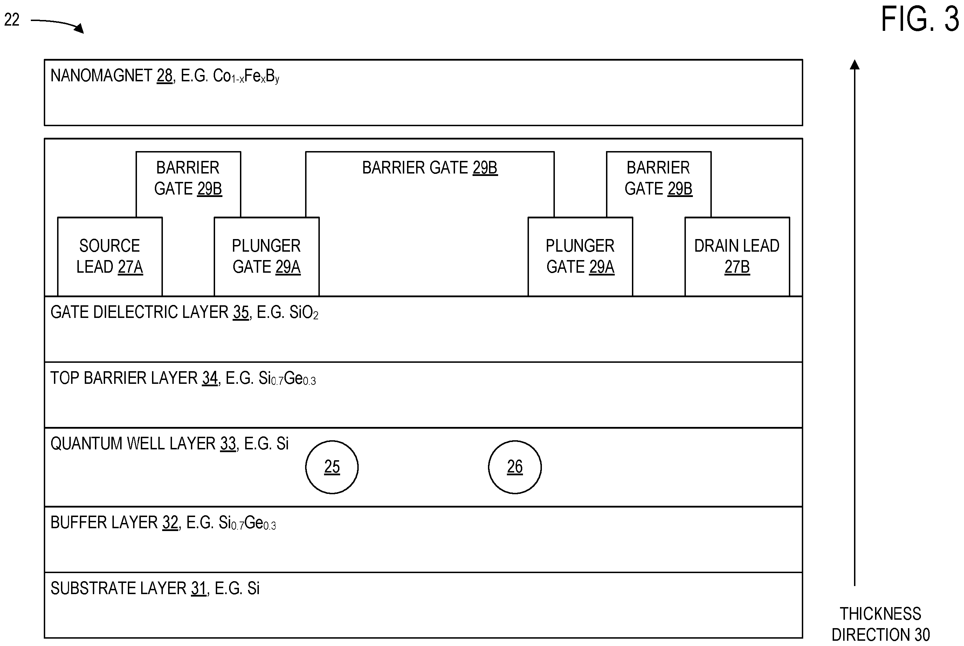

FIG. 3 shows a vertical cross-sectional view of a spin-based quantum-dot qubit 22 included in the quantum computing device 20, according to one example. In the example of FIG. 3, the spin-based quantum-dot qubit 22 includes a stack of a plurality of layers. A thickness direction 30 of the stack is shown in FIG. 3.

The plurality of layers includes one or more silicon layers. According to the example of FIG. 3, the spin-based quantum-dot qubit 22 includes a substrate layer 31. The substrate layer may, for example, be formed from, and thus include, silicon.

The spin-based quantum dot qubit 22 further includes a buffer layer 32 located above the substrate layer 31 in the thickness direction 30. The buffer layer may be a silicon-germanium (SiGe) alloy layer, which may, for example, include an SiGe alloy having a composition of Si_{0.7}Ge_{0.3}. In other examples, the buffer layer 32 may have some other composition. The buffer layer 32 provides electron confinement between layers of the spin-based quantum dot qubit 22.

The spin-based quantum dot qubit 22 further includes a quantum well layer 33 located above the buffer layer 32 in the thickness direction 30. The first quantum dot 25 and the second quantum dot 26 are located in the quantum well layer 33. For example, the quantum well layer 33 may be a silicon layer.

In examples in which the buffer layer 32 is an SiGe alloy layer, the ratio of silicon to germanium is selected such that electron confinement in the quantum well layer 33 is balanced with material strain. Electron confinement increases with increasing levels of germanium. Material strain decreases with increasing levels of silicon, thereby reducing a dislocation density of the buffer layer 32. The example composition Si_{0.7}Ge_{0.3} discussed above provides both a high level of electron confinement and a low dislocation density.

The spin-based quantum dot qubit 22 shown in FIG. 3 further includes a top barrier layer 34 located above the quantum well layer in the thickness direction 30. Similarly to the buffer layer 32, the top barrier layer 34 provides electron confinement between layers of the spin-based quantum dot qubit 22. The top barrier layer 34 may be an SiGe layer and may, for example, have the composition Si_{0.7}Ge_{0.3}.

The spin-based quantum dot qubit 22 further includes a gate dielectric layer 35 located above the top barrier layer 34 in the thickness direction 30. The gate dielectric layer 35 is an insulator that insulates the electrical leads 27 and the gate electrodes 29 from the top barrier layer 34. For example, the gate dielectric layer 35 may be a silicon dioxide (SiO₂) layer.

The spin-based quantum dot qubit 22 further includes a plurality of electrode gates located above the gate dielectric layer 35 in the thickness direction 30. The plurality of gate electrodes 29 includes a plurality of plunger gates 29A and a plurality of barrier gates 29B. In addition, a source lead 27A and a drain lead 27B are located above the second silicon layer 33 in the thickness direction 30. The source lead 27A and the drain lead 27B are the electrical leads via which electrons are transferred between the quantum dots and an electron source area. The source lead 27A and the drain lead 27B are respectively configured to provide electrons to the quantum dots and receive electrons from the quantum dots. The electron source area is an implanted area of the qubit grid 21 in some examples.

As discussed above with reference to FIG. 2B, the spin-based quantum-dot qubit 22 further includes a nanomagnet 28 located above the plurality of plunger gates 29A and the plurality of barrier gates 29B in the thickness direction 30. Thus, the nanomagnet 28 is located in a layer of the quantum computing device 20 provided above the quantum dots 25 and 26 in the thickness direction 30, and is located on an opposite side of the substrate layer 31 relative to the quantum dots 25 and 26.

The nanomagnet 28 includes an amorphous ferromagnetic alloy. As shown in the example of FIG. 3, the amorphous ferromagnetic alloy is a cobalt-iron-boron (CoFeB) alloy. In this example, the CoFeB alloy has a composition of Co₁₋ₓFeₓB_{y}, with 0 < x < 1 and 0.2 < y < 1.

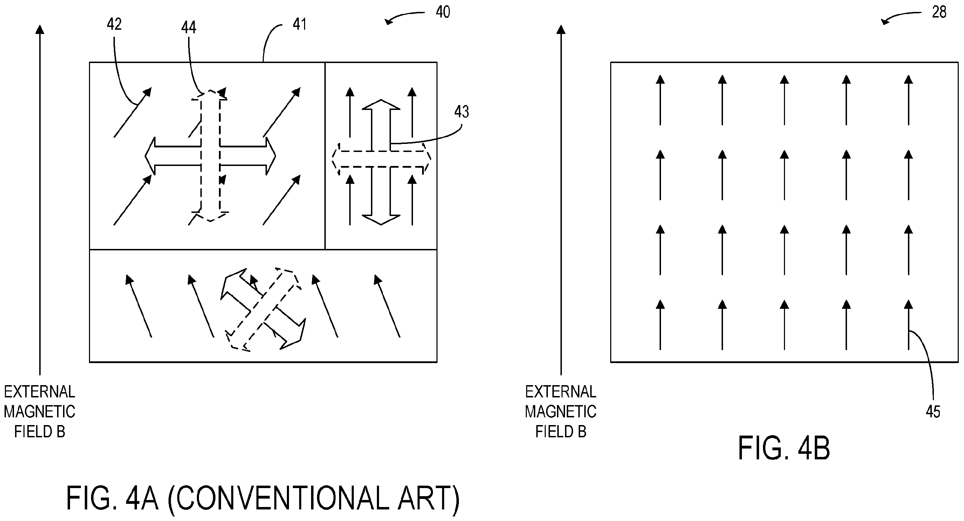

Using an alloy rather than an elemental material as the material of the nanomagnet 28 allows a stronger magnetic field to be achieved. FIG. 4A shows an example cross-sectional view of a portion of a conventional nanomagnet 40 formed from a crystalline ferromagnetic material. For example, the conventional nanomagnet 40 may be a crystalline cobalt nanomagnet. The conventional nanomagnet 40 is shown when subjected to an external magnetic field B during manufacturing. The external magnetic field B is applied in order to align the magnetic moments 42 within the alloy included in the conventional nanomagnet 40.

A plurality of crystal grains 41 are shown in FIG. 4A. The crystal grains 41 of the conventional nanomagnet 40 exhibit magnetocrystalline anisotropy. Since the crystal structure of cobalt is hexagonal, the magnetocrystalline anisotropy exhibited by the crystal grains 41 of the conventional nanomagnet 40 is uniaxial. Within each of the crystal grains 41, the crystalline cobalt has a respective magnetic easy axis 43. The magnetic moments 42 of the atoms included in each of the crystal grains 41 at least partially align with the external magnetic field B when the external magnetic field B is applied.

The magnetic easy axis 43 of a crystal grain 41 of a crystalline cobalt nanomagnet typically has a coercive field strength of H_{c} < 100 Oe. Each crystal grain 41 also has a magnetic hard axis 44 that is perpendicular to the magnetic easy axis 43 and typically has a coercive field strength of H_{c} > 4000 Oe. In addition, due to the variability in the angles of the magnetic moments 42, the conventional nanomagnet 40 generates a nonuniform magnetic field.

FIG. 4B shows an example cross-sectional view of a portion of the nanomagnet 28 of FIG. 2B. Similarly to in the example of FIG. 4A, the nanomagnet 28 is shown when an external magnetic field B is applied during manufacturing. As shown in the example of FIG. 4B, since the nanomagnet 28 is formed from an amorphous ferromagnetic alloy, the magnetic moments 45 of the atoms included in the nanomagnet 28 align themselves to the direction of the external magnetic field B without being rotated toward the direction of a magnetic easy axis. Accordingly, the magnetic moments 45 of the atoms included in the nanomagnet 28 are aligned with the external magnetic field B to a greater extent than in the conventional nanomagnet 40 of FIG. 4A. The nanomagnet 28 of FIG. 4B therefore exerts a stronger magnetic field on the quantum dots 25 and 26 than the conventional nanomagnet 40 would exert. During qubit operations performed at the quantum computing device 20, the magnetic field applied to the quantum dots typically has a strength between 0.3 T and 1 T. In some experiments performed at the quantum computing device 20, the maximum applied magnetic field reaches a strength between 5 T and 10 T.

Since forming the nanomagnet 28 included in a spin-based quantum computing device 20 from an amorphous ferromagnetic alloy such as CoFeB results in an increase in magnetic field strength, splitting between energy levels of the quantum dots 25 and 26 due to the Zeeman effect is also increased. In some examples, the nanomagnet 28 produces a magnetic field of equivalent strength to the magnetic field that would be produced by a conventional nanomagnet 40, except the nanomagnet 28 is smaller in size. This size reduction allows the overall size of the spin-based quantum-dot qubit 22 to be reduced. In addition, since the magnetic field produced by the nanomagnet 28 is decoupled from the crystallographic axes of crystal grains 41, the nanomagnet 28 produces a more uniform magnetic field than the conventional nanomagnet 40 of FIG. 4A. By providing a stronger and more uniform magnetic field than a conventional nanomagnet 40, the nanomagnet 28 discussed above allows the spins of the quantum dots 25 and 26 to be controlled with greater reliability.

Further, the disclosure comprises configurations according to the following clauses.
Clause 1. A quantum computing device comprising: a plurality of spin-based quantum-dot qubits that each include: one or more quantum dots; and a nanomagnet including an amorphous ferromagnetic alloy.
Clause 2. The quantum computing device of clause 1, wherein the amorphous ferromagnetic alloy is a cobalt-iron-boron (CoFeB) alloy.
Clause 3. The quantum computing device of clause 2, wherein the CoFeB alloy has a composition of Co₁₋ₓFeₓB_{y}, with 0 < x < 1 and 0.2 < y < 1.
Clause 4. The quantum computing device of clause 1, wherein: each of the plurality of spin-based quantum-dot qubits includes a stack of a plurality of layers, the stack having a thickness direction; and the nanomagnet is located in a layer of the plurality of layers that is provided above the one or more quantum dots in the thickness direction.
Clause 5. The quantum computing device of clause 1, wherein each of the plurality of spin-based quantum-dot qubits is a double-quantum-dot qubit that includes a first quantum dot and a second quantum dot.
Clause 6. The quantum computing device of clause 1, wherein each of the spin-based quantum-dot qubits further includes a plurality of barrier gates.
Clause 7. The quantum computing device of clause 1, wherein each of the spin-based quantum-dot qubits further includes a plurality of plunger gates.
Clause 8. The quantum computing device of clause 1, wherein each of the spin-based quantum-dot qubits further includes one or more silicon layers.
Clause 9. The quantum computing device of clause 1, wherein each of the spin-based quantum-dot qubits further includes one or more silicon-germanium (SiGe) alloy layers.
Clause 10. The quantum computing device of clause 1, wherein the one or more quantum dots are formed from silicon.
Clause 11. The quantum computing device of clause 1, wherein the nanomagnet is formed via sputtering.
Clause 12. A nanomagnet configured to apply an external magnetic field to one or more quantum dots included in a spin-based quantum computing device, wherein the nanomagnet includes an amorphous ferromagnetic alloy.
Clause 13. The nanomagnet of clause 12, wherein the amorphous ferromagnetic alloy is a cobalt-iron-boron (CoFeB) alloy.
Clause 14. The nanomagnet of clause 13, wherein the CoFeB alloy has a composition of Co₁₋ₓFeₓB_{y}, with 0 < x < 1 and 0.2 < y < 1.
Clause 15. The nanomagnet of clause 12, wherein the nanomagnet is located in a layer of the spin-based quantum computing device provided above the one or more quantum dots in a thickness direction.
Clause 16. The nanomagnet of clause 15, wherein the nanomagnet is located on an opposite side of a substrate layer relative to the one or more quantum dots.
Clause 17. The nanomagnet of clause 12, wherein the nanomagnet is formed via sputtering.
Clause 18. A spin-based quantum-dot qubit that includes: a substrate layer; a buffer layer located above the substrate layer in a thickness direction; a quantum well layer in which a first quantum dot and a second quantum dot are located, wherein the quantum well layer is located above the buffer layer in the thickness direction; a top barrier layer located above the quantum well layer in the thickness direction; a gate dielectric layer located above the top barrier layer in the thickness direction; a plurality of plunger gates and a plurality of barrier gates located above the gate dielectric layer in the thickness direction; and a nanomagnet located above the plurality of plunger gates and the plurality of barrier gates in the thickness direction, wherein the nanomagnet includes an amorphous ferromagnetic alloy.
Clause 19. The spin-based quantum-dot qubit of clause 18, wherein the amorphous ferromagnetic alloy is a cobalt-iron-boron (CoFeB) alloy.
Clause 20. The spin-based quantum-dot qubit of clause 19, wherein the CoFeB alloy has a composition of Co₁₋ₓFeₓB_{y}, with 0 < x < 1 and 0.2 < y < 1.

## Claims

1. A nanomagnet (28), configured to apply an external magnetic field to one or more quantum dots (25, 26) included in a spin-based quantum computing device (20), wherein the nanomagnet (28) includes an amorphous ferromagnetic alloy.

2. The nanomagnet (28) of claim 1, wherein the amorphous ferromagnetic alloy is a cobalt-iron-boron (CoFeB) alloy.

3. The nanomagnet (28) of claim 2, wherein the CoFeB alloy has a composition of Co₁₋ₓFeₓB_{y}, with 0 < x < 1 and 0.2 < y < 1.

4. The nanomagnet (28) of any one of claims 1-3, wherein the nanomagnet is formed via sputtering.

5. A quantum computing device (20), comprising:
a plurality of spin-based quantum-dot qubits (22) that each includes:
one or more quantum dots (25, 26); and
a nanomagnet (28) according to any one of claims 1 to 4.

6. The quantum computing device (20) of claim 5, wherein:
each of the plurality of spin-based quantum-dot qubits (22) includes a stack of a plurality of layers (31, 32, 33, 34, 35), the stack having a thickness direction (30); and
the nanomagnet (28) is located in a layer of the plurality of layers that is provided above the one or more quantum dots (25, 26) in the thickness direction (30).

7. The quantum computing device (20) of any one of claims 5 or 6, wherein each of the plurality of spin-based quantum-dot qubits (22) is a double-quantum-dot qubit that includes a first quantum dot (25) and a second quantum dot (26).

8. The quantum computing device (20) of any one of claims 5-7, wherein each of the spin-based quantum-dot qubits (22) further includes a plurality of barrier gates (29B).

9. The quantum computing device (20) of any one of claims 5-8, wherein each of the spin-based quantum-dot qubits (22) further includes a plurality of plunger gates (29A).

10. The quantum computing device (20) of any one of claims 5-9, wherein each of the spin-based quantum-dot qubits (22) further includes one or more silicon layers.

11. The quantum computing device (20) of any one of claims 5-10, wherein each of the spin-based quantum-dot qubits (22) further includes one or more silicon-germanium (SiGe) alloy layers.

12. The quantum computing device (20) of any one of claims 5-11, wherein the one or more quantum dots (25, 26) are formed from silicon.

13. The quantum computing device (20) of claim 6, wherein the nanomagnet (28) is located on an opposite side of a substrate layer (31) relative to the one or more quantum dots (25, 26).

14. The quantum computing device (20) of any one of claims 5-13, wherein the nanomagnet (28) applies a magnetic field to the quantum dots (25, 26) in the range of 0.3 T and 10 T.

15. A spin-based quantum-dot qubit (22), comprising:
a substrate layer (31);
a buffer layer (32) located above the substrate layer (31) in a thickness direction (30);
a quantum well layer (33) in which a first quantum dot (25) and a second quantum dot (26) are located, wherein the quantum well layer (33) is located above the buffer layer (32) in the thickness direction (30);
a top barrier layer (34) located above the quantum well layer (33) in the thickness direction (30);
a gate dielectric layer (35) located above the top barrier layer (34) in the thickness direction (30);
a plurality of plunger gates (29A) and a plurality of barrier gates (29B) located above the gate dielectric layer (35) in the thickness direction (30); and
a nanomagnet (28) located above the plurality of plunger gates (29A) and the plurality of barrier gates (29B) in the thickness direction (30), wherein the nanomagnet (28) is according to any one of claims 1 to 4.
